# EUROPEAN PATENT SPECIFICATION

(11) **EP 2 415 909 B1**
(45) Date of publication and mention of the grant of the patent: **11.05.2016**
(21) Application number: 10758459.1
(22) Date of filing: 19.03.2010
(51) Int. Cl.: C30B 29/36, C30B 25/00, C30B 23/00, C30B 33/06

(54) **BONDED SUBSTRATE, AND METHOD FOR MANUFACTURING BONDED SUBSTRATE**
GEBONDETES SUBSTRAT, UND VERFAHREN ZUR HERSTELLUNG DES GEBONDETEN SUBSTRATS
SUBSTRAT DE LIAISON, ET PROCÉDÉ DE FABRICATION D'UN SUBSTRAT DE LIAISON

(30) Priority: 31.03.2009 JP 2009085294
(43) Date of publication of application: 08.02.2012
(73) Proprietor: Bridgestone Corporation, Tokyo 104-8340 (JP)
(72) Inventor: USHITA, Kazuhiro, Kodaira-shi, Tokyo 187-8531 (JP)
(74) Representative: Oxley, Robin John George
(86) International application number: PCT/JP2010/054859
(87) International publication number: WO 2010/113685

(56) References cited:
- EP-A1- 1 901 345
- EP-A2- 0 594 030
- WO-A1-01/09412
- WO-A1-2006/138422
- WO-A1-2008/096194
- JP-A- 9 077 595
- JP-A- 11 147 795
- JP-A- 2002 047 100
- US-A1- 2002 096 106
- US-A1- 2004 009 649
- US-A1- 2004 134 418

## Description

### TECHNICAL FIELD

The present invention relates to: a bonded substrate having a single crystalline wafer made of a single crystalline body and a supporting substrate bonded on the single crystalline wafer, and a method for manufacturing the bonded substrate.

### BACKGROUND ART

Conventionally, it is found that a single crystalline body consisting of silicon, silicon carbide, gallium nitride, aluminum nitride or the like has its superior high frequency properties as well as its superior heat resistance or withstand voltage. Thus, a wafer made of these single crystal bodies (hereinafter, appropriately abbreviated as a single crystalline wafer) is widely known as a semiconductor material to be employed in an LED device, a power device, or a high frequency device of a next generation (for example, Patent Document 1).

Such a single crystalline wafer has its superior properties, whereas its related manufacturing method is complicated and its related price is high. Therefore, a so called bonded substrate, which is obtained by bonding a supporting substrate for supporting a single crystalline wafer and a thin-filmed single crystalline wafer with each other, is widely known. As a method for bonding a single crystalline wafer and a supporting substrate with each other without using an adhesive agent, for example, there is proposed a heating and pressurization bonding method, a surface activation bonding method with ion beam irradiation onto a bonding face, or a bonding method via a hydrophilic group with hydrophilizing treatment and the like.

Such a bonded substrate functions as a material for semiconductor device fabrication by disposing a single crystalline wafer at a site at which the substrate is utilized as a semiconductor material. In addition, such a bonded substrate ensures its required substrate thickness and strength on use by means of a supporting substrate.
Attention is drawn to the disclosures of WO 2006/138422 A1, EP 1,901,345 A1 and US 2002/096106.

### PRIOR ART DOCUMENT

### PATENT DOCUMENT

Patent Document 1: JP-A-2005-8472 (Pages 4 to 6)

### SUMMARY OF THE INVENTION

The conventional bonded substrate described above has entailed the following problem. That is, in a case where a supporting substrate is manufactured by means of sintering treatment, since air holes are formed on the supporting substrate, irregularities are formed on a surface of the supporting substrate. Therefore, if the supporting substrate is bonded on a single crystalline wafer, a gap is formed between the single crystalline wafer and the supporting substrate, the bonding faces do not come into intimate contact with each other sufficiently, and there has been a problem that a sufficient bonding strength is not obtained.

Accordingly, it is an object of the present invention or provide a supporting substrate to be bonded on a single crystalline wafer, which is capable of restraining a gap to be formed between the single crystalline wafer and the supporting substrate, a bonded substrate, a method for manufacturing the supporting substrate, and a method for manufacturing the bonded substrate.

To solve the above problems, the present invention has following feature. First, a first aspect or the present invention is provided according to claim 1.

Since an arithmetic average roughness of a surface of a coating layer coming into contact with the single crystalline wafer is 1 nanometer or less, it is possible to restrain a gap from being formed between the coating layer and the single crystalline wafer.

Therefore, the supporting substrate is capable of restraining a gap from being formed between the single crystalline wafer and the supporting substrate.

A second feature of the present invention according to the first feature is summarized as that the coating layer is evaporated on the silicon carbide polycrystalline substrate by means of a physical vapor deposition method or a chemical vapor deposition method.

### [DELETED]

A third feature of the present invention is summarized as a bonded substrate (bonded substrate 100) according to claim 3.

A fourth feature of the present invention is provided according to claim 4.

### [DELETED]

According to the features of the present invention, provided are a bonded substrate, which is capable of restraining a gap to be formed between the single crystalline wafer and the supporting substrate, and a method for manufacturing the bonded substrate.

### BRIEF DESCRIPTION OF THE DRAWINGS

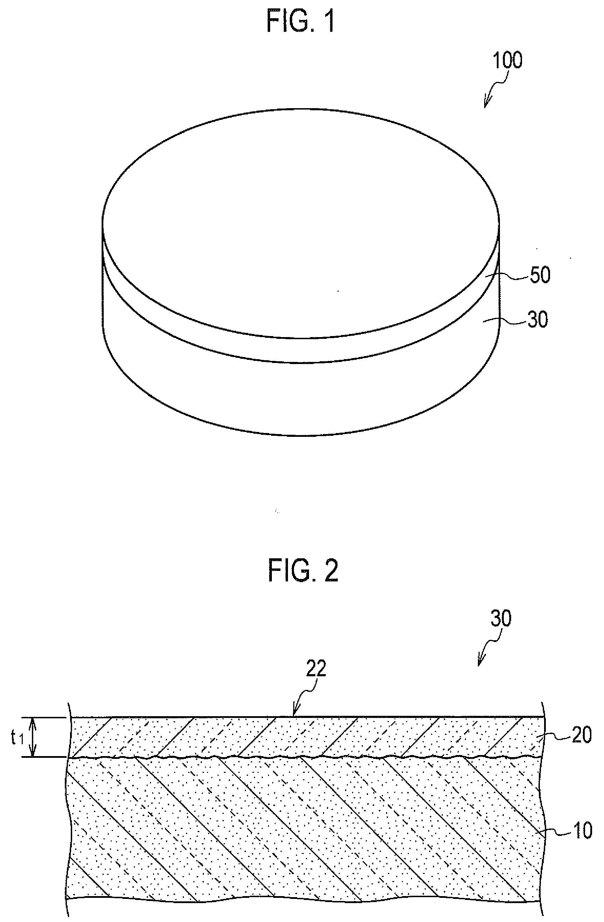

[Fig. 1] Fig. 1 is a perspective view of a bonded substrate according to an embodiment of the present invention.
[Fig. 2]
   Fig. 2 is a sectional view of a supporting substrate according to an embodiment of the present invention.
[Fig. 3]

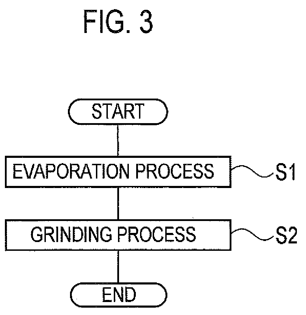

   Fig. 3 is a flowchart showing a method for manufacturing the support substrate, according to an embodiment of the present invention.
[Fig. 4]

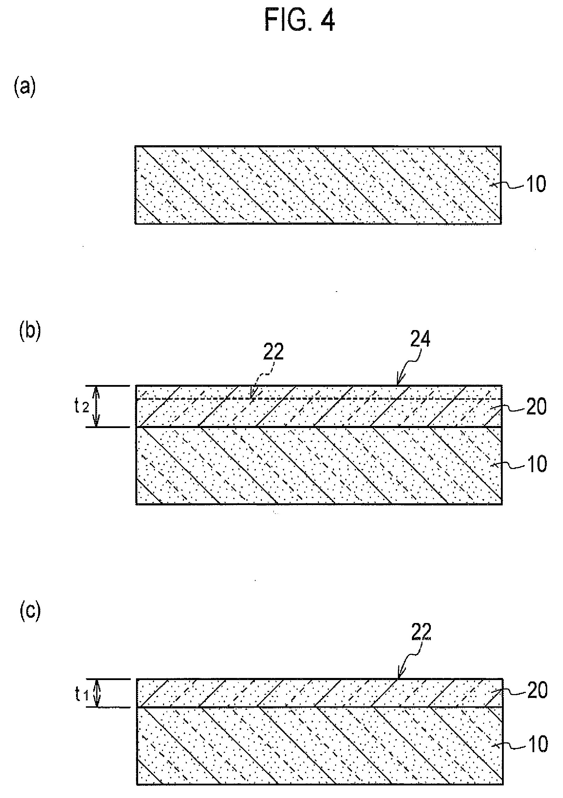

   Fig 4 is a view showing a method for manufacturing the support substrate, according to an embodiment of the present invention.
[Fig. 5]

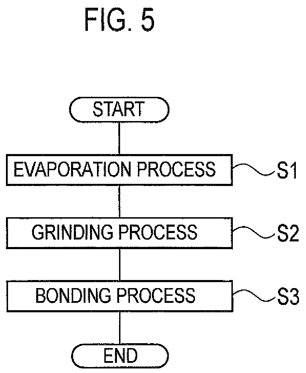

   Fig. 5 is a flowchart showing a method for manufacturing the bonded substrate, according to an embodiment of the present invention.

### BEST MODES FOR CARRYING OUT THE INVENTION

Next, a supporting substrate, a bonded substrate, a method for manufacturing the supporting substrate, and a method for manufacturing the bonded substrate, according to an embodiment of the present invention, will be described with reference to the drawings. Specifically, the above descriptions will be furnished as to (1) Entire Structure of Bonded substrate, (2) Detailed Description of Structure of Supporting Substrate, (3) Method for Manufacturing Supporting Substrate, (4) Method for Manufacturing Bonded substrate, (5) Comparative Evaluation, (6) Functions and Advantageous Effects, and (7) Other Embodiments.

In the following description of the drawings, the same constituent elements are designated by the same reference numerals. However, it should be kept in mind that the drawings are merely schematically shown, and the ratios of each dimension or the like are different from the real ones.

Therefore, specific dimensions, etc., should be determined in consideration of the following description. Of course, constituent elements with their different dimensional interrelationships and ratios are included in the respective drawings as well.

### (1) Entire Structure of Bonded substrate

Fig. 1 is a perspective view of a bonded substrate 100 according to an embodiment of the present invention. As shown in Fig. 1, the bonded substrate is provided with: a single crystalline wafer 50 made of a single crystalline body; and a supporting substrate 30 to be bonded on the single crystalline wafer 50. Specifically, the single crystalline wafer 50 is made of a single crystalline body consisting of Si, GaN, SiC, AlN or the like.

The bonded substrate 100 is employed as a semiconductor device substrate such as an LED device, a power device, or a high frequency device of a next generation. The bonded substrate 100 ensures its required substrate thickness and strength on use by means of the supporting substrate 30.

### (2) Detailed Description of Structure of Supporting Substrate

Fig. 2 is a sectional view of a supporting substrate 30 according to an embodiment of the present invention. As shown in Fig. 2, the supporting substrate 30 is provided with: a silicon carbide polycrystalline substrate 10 made of a polycrystalline body consisting of silicon carbide; and a coating layer 20 to be evaporated on the silicon carbide polycrystalline substrate 10.

The silicon carbide polycrystalline substrate 10 is made of a polycrystalline body consisting of silicon carbide, which can be inexpensively manufactured by means of sintering treatment such as hot press.

The coating layer 20 is made of silicon carbide, and is provided with a contact face 22 that comes into contact with the single crystalline wafer 50. The coating layer 20 is evaporated on the silicon carbide polycrystalline substrate 10, and thereafter, the evaporated coating layer is ground. Specifically, the coating layer 20 is evaporated on the silicon carbide polycrystalline substrate 10 by means of a physical vapor deposition method, a chemical vapor deposition method, or any other evaporation method or plating treatment and the like.

An average in thickness t1 of the coating layer 20, which is a thickness in the growth direction of the coating layer 20, is 5 microns or more to 10 microns or less. A surface of the coating layer 20 that comes into contact with the single crystalline wafer 50, namely, an arithmetical average roughness Ra of a contact face 22 is 1 nanometer or less.

A planer precision of the contact face 22 is 30 microns or less. Specifically, a BOW that is indicative of a difference in center face of the single crystalline wafer 50 from a reference face and a WARP that is indicative of a difference between a maximum value and a minimum value in distance from a best fit reference face of a center face that is obtained by compensating for a deformation component due to a self-weight up to a center face of the single crystalline wafer 50, in a state in which the contact face 22 is neither adsorbed nor fixed, are respectively 30 microns or less,.

### (3) Method for Manufacturing Supporting Substrate

Next, a method for manufacturing a supporting substrate, according to the embodiment, will be described with reference to Figs. 3 and 4. Fig. 3 is a flowchart showing the method for manufacturing the supporting substrate, according to the embodiment. Fig. 4 is a sectional view of a substrate for indicating the method for manufacturing the supporting substrate, according to the embodiment. Specifically, the method for manufacturing the supporting substrate 30 includes the steps set forth in the sections (3. 1) Evaporation Process and (3. 2) Grinding Process.

### (3. 1) Evaporation Process

As shown in Fig. 3 and Fig. 4(a) and (b), in the evaporation process of step Si, silicon carbide is evaporated on the silicon carbide polycrystalline substrate 10 made of a silicon carbide polycrystalline body, and the coating layer 20 made of thickness t2 (10 microns) is formed. Specifically, the coating layer 20 made of 5 microns or more is formed on the silicon carbide polycrystalline substrate 10 by means of a physical vapor deposition method, a chemical vapor deposition method, or any other evaporation method or plating treatment and the like.

### (3. 2) Grinding Process

As shown in Fig. 3 and Fig. 4(c), in the grinding process of step S2, in the silicon carbide polycrystalline substrate 10, grinding is applied onto an evaporation face 24 of the coating layer 20 that is a face on which evaporation has been made. Specifically, mechanical grinding or chemical and mechanical grinding is applied onto the evaporation face 24 of the coating layer 20.

In the grinding process of step S2, an arithmetic average roughness of the evaporation face 24 is formed to be 1 nanometer or less by means of the abovementioned grinding to thereby form a contact face 22. The thickness t1 of the coating layer 20 onto which grinding is applied is 5 microns or more to 10 microns or less. A supporting substrate 30 is manufactured by means of the abovementioned process.

### (4) Method for Manufacturing Bonded substrate

Next, a method for manufacturing a bonded substrate, according to the embodiment, will be described with reference to Fig. 5. Fig. 5 is a flowchart showing the method for manufacturing the bonded substrate, according to the embodiment.

Since descriptions of steps S1 and S2 are identical to those of the supporting substrate 30 described above, these descriptions are omitted here.

### (4. 1) Bonding Process

In the bonding step of step S3, faces onto which grinding is applied in the grinding step of step S2, i.e., the contact face 22 and the single crystalline wafer 50 are bonded with each other. A bonded substrate 100 is manufactured by means of the abovementioned process.

### (5) Comparative Evaluation

Next, comparative evaluation made by employing supporting substrates according to Comparative Examples and Working Example that follow will be described in order to further clarify advantageous effects of the present invention. Specifically, the above descriptions will be furnished as to (5. 1) Evaluation Method and (5. 2) Evaluation Result. It should be noted that the present invention is not limited by these examples.

### (5. 1) Evaluation Method

By employing supporting substrates of Comparative Examples and Working Example, the steps set forth in the sections (5. 1. 1) Observation of Surface State of Supporting Substrate and (5. 1. 2) Surface Roughness Evaluation, were performed. A specific description will be furnished as to the supporting substrates according to Comparative Examples and Working Example, which were employed in comparative evaluation. A diameter size of a wafer constituting the supporting substrates is 4 pinches.

Each of the supporting substrates has its different structure of coating layer. Specifically, an arithmetic average roughness of a surface of the coating layer constituting a supporting substrate according to Working Example is 1 nanometer or less. A supporting substrate according to Comparative Example is not provided with a coating layer, and grinding is not applied onto a surface of a coating layer that constitutes a supporting substrate according to Comparative Example 2.

The supporting substrate according to Working Example is identical to the support substrate 30 according to the embodiment.

### (5. 1. 1) Observation of Surface State of Supporting Substrate

Observation method: Irregularities of a surface of each supporting substrate was observed by means of optical microscope.

### (5. 1. 2) Surface Roughness Evaluation

Evaluation method: Surface roughness of each support substrate was measured. Specifically, a computational average roughness Ra was specified.

### (5. 2) Evaluation Result

Evaluation results obtained by employing the supporting substrates according to Comparative Example 1, Comparative Example 2, and Working Example, mentioned above, will be described with reference to Table 1.

**[Table 1]**

| | Comparative Example 1 | Comparative Example 2 | Working Example |
|---|---|---|---|
| Observation by means of electronic microscope | Air holes are present. | Air holes are present. | No air holes are present |
| Arithmetic average roughness Ra | 1.5 nanometers | 10 to 100 nanometers | < 1.0 nanometer |

On the supporting substrate according to Working Example, such air holes that had been observed on the supporting substrates according to Comparative Examples 1 and 2 were hardly observed, and the arithmetic average roughness also indicated a small value.

### (6) Functions and Advantageous Effects

As described above, such a support substrate 30 according to the embodiment is provided with a coating layer 20 made of silicon carbide between a silicon carbide polycrystalline substrate 10 and a single crystalline wafer 50. Since the arithmetic average roughness of the surface of the coating layer 20 that comes into contact with the single crystalline wafer 50 is 1 nanometer or less, it is possible to restrain a gap from being formed between the coating layer and the single crystalline wafer 50. Therefore, the supporting substrate 30 is capable of restraining a gap from being formed between the single crystalline wafer 50 and the supporting substrate 30.

In a case where the arithmetic average roughness of the surface of the coating layer 20 that comes into contact with the single crystalline wafer 50 is greater than 1 nanometer, a gap is formed between the single crystalline wafer 50 and the supporting substrate 30. Accordingly, the bonding faces do not come into intimate contact with each other sufficiently, and a sufficient bonding strength is not obtained.

In the embodiment, since the silicon carbide polycrystalline substrate 10 can be manufactured by means of sintering treatment such as hot press, the supporting substrate 30 can be inexpensively manufactured.

In the embodiment, the coating layer 20 is evaporated on the silicon carbide polycrystalline substrate 10 by means of a physical vapor deposition method or a chemical vapor deposition method. Thus, the coating layer 20 has its heat resistance, and is fixedly adhered to the silicon carbide polycrystalline substrate 10.

In the embodiment, a thickness t1 of the coating layer 20 is 5 microns or more. Thus, a contact face 22 can be formed without being affected by irregularities of the surface of the silicon carbide polycrystalline substrate 10 on which the coating layer 20 is evaporated.

In the embodiment, the thickness t1 of the coating layer 20 is 10 microns or less. If thickness t1 of the coating layer 20 is greater than 10 microns, the manufacturing cost becomes high, which is not preferable.

In the embodiment, it is possible to restrain a gap from being formed between the single crystalline wafer 50 and the supporting substrate 30, and the bonded substrate 100 can be manufactured at a low cost by employing the supporting substrate 30 with its less gap.

In the embodiment, the bonded substrate 100 ensures its required substrate thickness and strength on use by means of the supporting substrate 30. In addition, since the silicon carbide polycrystalline substrate 10 constituting the supporting substrate 30 can be manufactured by means of sintering treatment, the supporting substrate 30 with its large aperture can be readily manufactured. Therefore, the bonded substrate 100 with its large aperture can be manufactured more readily than the single crystalline wafer that is entirely made of a single crystalline body.

In the embodiment, the method for manufacturing the supporting substrate 30 includes the step S1 of evaporating silicon carbide on the silicon carbide polycrystalline substrate 10 made of a silicon carbide polycrystalline body and the step S2 of applying grinding onto a face on which evaporation has been made on the silicon carbide polycrystalline substrate 10 and then forming the arithmetic average roughness of the face on which evaporation has been made to be 1 nanometer or less.

Thus, it is possible to restrain a gap that is formed relative to the single crystalline wafer 50, by means of a single method, in comparison with a method of bonding the conventional silicon carbide polycrystalline substrate 10 and the single crystalline wafer 50 with each other. In addition, it is possible to further restrain a gap relative to the single crystalline wafer 50 by applying grinding onto the face on which evaporation has been made.

In the embodiment, the coating layer 20 is made of silicon carbide. Therefore, the coating layer 20 has its properties that its heat conductivity is high, its temperature is likely to lower from a high temperature, and its heat resistance is superior.

### (7) Other Embodiments

The scope of the invention is defined by the appended claims. For illustrative purposes only, other embodiments are presented, that may lie outside of the scope of the invention.

For example, the embodiments of the present invention can be modified as follows. The planar precision of the contact face 22 in the abovementioned embodiment is 30 microns or less. Specifically, the BOW and WARP are respectively 30 microns or less.

The BOW is indicative of a difference of a center face of the single crystalline wafer 50 from a reference face. The WARP is indicative of a difference between a maximum value and a minimum value of a distance from a reference face (a best fit reference face) of a center face having compensated for a deformation component due to a self-weight up to a center face of the single crystalline wafer 50, in a state in which the contact face 22 is neither adsorbed nor fixed.

However, the planer precision of the contact face 22 can be modified according to an outer diameter and a thickness of the single crystalline wafer 50 without being limitative thereto. For example, a single crystalline wafer, which is identical in outer diameter to the single crystalline wafer 50, and which is greater in thickness than that of the single crystalline wafer 50, is unlikely to be deformed. Thus, in a case where the thickness of the single crystalline wafer 50 is increased, further high planar precision is required for the contact face 22. On the other hand, a single crystalline wafer, which is identical in outer diameter to the single crystalline wafer 50, and is smaller in thickness than the single crystalline wafer 50, is likely to be deformed. Therefore, in a case where the thickness of the single crystalline wafer 50 is decreased, the planer precision required for the contact face 22 is loosened.

While the supporting substrate 30 in the abovementioned embodiments was employed as a substrate to be bonded on the single crystalline wafer 50, the coating layer 20 may be further grown by means of a physical vapor deposition method or a chemical vapor deposition method without being limitative thereto. According to this supporting substrate, the supporting substrate 30 and the single crystalline wafer 50 do not need to be bonded with each other, and in the bonding process, entry of impurities or the like between the supporting substrate 30 and the single crystalline wafer 50 can be prevented.

The abovementioned silicon carbide polycrystalline substrate 10 in the embodiment may be formed of a material suitable for a structure or the like of the coating layer 20 or the single crystalline wafer 50 without being limitative to a polycrystalline body consisting of silicon carbide.

### INDUSTRIAL APPLICABILITY

According to the present invention, in a case where a wafer and a substrate are used while they are bonded with each other, since a gap between the wafer and the substrate can be reduced, and the bonding strength can be increased, the present invention is applicable to a bonded substrate obtained by bonding a supporting substrate on a thin-filmed single crystalline wafer in order to ensure the strength of the thin-filmed single crystalline wafer.

### DESCRIPTION OF REFERENCE NUMERALS

10···silicon carbide polycrystalline substrate, 20···coasting layer, 22···contract face, 24···evaporation face, 30···supporting substrate, 50 single crystalline wafer, 100···bonded substrate.

## Claims

1. A bonded substrate (100) comprising:
a single crystalline wafer (50) made of a single crystalline body; and
a supporting substrate (30) bonded on the single crystalline wafer (50), the supporting substrate (30) comprising:
a silicon carbide polycrystalline substrate (10) made of a silicon carbide polycrystalline body; and
a coating layer (20) evaporated on the silicon carbide polycrystalline body, wherein
the coating layer (20) is made of silicon carbide and is in contact with the single crystalline wafer (50), and
an arithmetic average roughness of a surface of the coating layer (20) that is in contact with the single crystalline wafer (50) is 1 nanometer or less and the planar precision of the contact face (22) of the coating layer (20) is 30 microns or less, wherein
a thickness of the coating layer (20) is 5 microns or more to 10 microns or less.

2. The bonded substrate (100) according to claim 1, wherein
the coating layer (20) is evaporated on the silicon carbide polycrystalline substrate (10) by means of a physical vapor deposition method or a chemical vapor deposition method.

3. The bonded substrate (100) according to claim 1 or 2, wherein the silicon carbide polycrystalline substrate (10) constituting the supporting substrate (30) is manufactured by means of sintering treatment.

4. A method for manufacturing a bonded substrate (100) which has a single crystalline wafer (50) made of a single crystalline body and a supporting substrate (30) bonded on the single crystalline wafer (50), the method comprising the steps of:
evaporating silicon carbide on a silicon carbide polycrystalline substrate (10) made of a silicon carbide polycrystalline body, and thereby forming a coating layer (20); and
applying grinding onto the evaporation face (24) of the coating layer (20), as to allow an arithmetic average roughness of a surface of the silicon carbide to be 1 nanometer or less, and allow the planar precision of the surface of the silicon carbide to be 30 microns or less, and allow a thickness of the coating layer (20) to be 5 microns or more to 10 microns or less; and
bonding the surface of the coating layer (20) to which the grinding is applied and the single crystalline wafer (50) with each other.

5. The method for manufacturing a bonded substrate (100) according to claim 4, wherein
the coating layer (20) is evaporated on the silicon carbide polycrystalline substrate (10) by means of a physical vapor deposition method or a chemical vapor deposition method.

6. The method for manufacturing a bonded substrate (100) according to claim 4 or 5, wherein
the silicon carbide polycrystalline substrate (10) constituting the supporting substrate (30) is manufactured by means of sintering treatment.

## Patentansprüche

1. Gebondetes Substrat (100), umfassend:
einen einkristallinen Wafer (50), der aus einem einkristallinen Körper hergestellt ist; und
ein Trägersubstrat (30), das an den einkristallinen Wafer (50) gebondet ist, wobei das Trägersubstrat (30) Folgendes umfasst:
ein polykristallines Siliciumcarbidsubstrat (10), das aus einem polykristallinen Siliciumcarbidkörper hergestellt ist; und
eine Beschichtungsschicht (20), die auf den polykristallinen Siliciumcarbidkörper aufgedampft ist, wobei
die Beschichtungsschicht (20) aus Siliciumcarbid hergestellt ist und sich in Kontakt mit dem einkristallinen Wafer (50) befindet, und
eine arithmetische Mittelwertrauheit einer Oberfläche der Beschichtungsschicht (20), die sich in Kontakt mit dem einkristallinen Wafer (50) befindet, 1 Nanometer oder weniger beträgt und die planare Präzision der Kontaktfläche (22) der Beschichtungsschicht (20) 30 Mikron oder weniger beträgt, wobei
eine Dicke der Beschichtungsschicht (20) 5 Mikron oder mehr bis 10 Mikron oder weniger beträgt.

2. Gebondetes Substrat (100) nach Anspruch 1, wobei
die Beschichtungsschicht (20) auf das polykristalline Siliciumcarbidsubstrat (10) durch ein physikalisches Gasphasenabscheidungsverfahren oder ein chemisches Gasphasenabscheidungsverfahren aufgedampft wird.

3. Gebondetes Substrat (100) nach Anspruch 1 oder 2, wobei das polykristalline Siliciumcarbidsubstrat (10), das das Trägersubstrat (30) darstellt, durch eine Sinterbehandlung hergestellt wird.

4. Verfahren zur Herstellung eines gebondeten Substrats (100), das einen einkristallinen Wafer (50) aufweist, der aus einem einkristallinen Körper und einem Trägersubstrat (30) hergestellt ist, das auf den kristallinen Wafer (50) gebondet ist, wobei das Verfahren die Schritte umfasst des:
Aufdampfens von Siliciumcarbid auf ein polykristallines Siliciumscarbidsubstrat (10), das aus einem polykristallinen Siliciumcarbidkörper hergestellt ist, und dadurch Bildens einer Beschichtungsschicht (20); und
Anwendens von Schleifen auf der Verdampfungsfläche (24) der Beschichtungsschicht (20),
umso zu gestatten, dass eine arithmetische Mittelwertrauheit einer Oberfläche des Siliciumcarbids 1 Nanometer oder weniger beträgt, und zu gestatten, dass die planare Präzision der Oberfläche des Siliciumcarbids 30 Mikron oder weniger beträgt, und zu gestatten, dass eine Dicke der Beschichtungsschicht (20) 5 Mikron oder mehr bis 10 Mikron oder weniger beträgt; und
Bondierens der Oberfläche der Beschichtungsschicht (20), auf der das Schleifen angewendet wird, und des einkristallinen Wafers (50) aneinander.

5. Verfahren für die Herstellung eines gebondeten Substrats (100) nach Anspruch 4, wobei
die Beschichtungsschicht (20) auf dem polykristallinen Siliciumcarbidsubstrat (10) durch ein physikalisches Gasabscheidungsverfahren oder chemisches Gasabscheidungsverfahren verdampft wird.

6. Verfahren für die Herstellung eines gebondeten Substrats (100) nach Anspruch 4 oder 5, wobei
das polykristalline Siliciumcarbidsubstrat (10), das das Trägersubstrat (30) bildet, durch Sinterbehandlung hergestellt wird.

## Revendications

1. Substrat lié (100) comprenant:
une plaquette cristalline unique (50) constituée d'un corps cristallin unique; et
un substrat de support (30) lié sur la plaquette cristalline unique (50), le substrat de support (30) comprenant:
un substrat polycristallin de carbure de silicium (10) constitué d'un corps polycristallin de carbure de silicium; et
une couche de revêtement (20) évaporée sur le corps polycristallin de carbure de silicium, où
la couche de revêtement (20) est constituée de carbure de silicium et se trouve en contact avec la plaquette cristalline unique (50), et
une rugosité moyenne arithmétique d'une surface de la couche de revêtement (20) qui se trouve en contact avec la plaquette cristalline unique (50) est de 1 nanomètre ou moins et la précision planaire de la face de contact (22) de la couche de revêtement (20) est de 30 microns ou moins, où
une épaisseur de la couche de revêtement (20) est de 5 microns ou plus à 10 microns ou moins.

2. Substrat lié (100) selon la revendication 1, où
la couche de revêtement (20) est évaporée sur le substrat polycristallin de carbure de silicium (10) à l'aide d'un procédé de dépôt physique en phase vapeur ou d'un procédé de dépôt chimique en phase vapeur.

3. Substrat lié (100) selon la revendication 1 ou 2, où le substrat polycristallin de carbure de silicium (10) constituant le substrat de support (30) est fabriqué à l'aide d'un traitement de frittage.

4. Procédé de fabrication d'un substrat lié (100) qui a une plaquette cristalline unique (50) constituée d'un corps cristallin unique et d'un substrat de support (30) lié sur la plaquette cristalline unique (50), le procédé comprenant les étapes de:
évaporation du carbure de silicium sur un substrat polycristallin de carbure de silicium (10) constitué d'un corps polycristallin de carbure de silicium, et formant de là une couche de revêtement (20); et
application d'un meulage sur la face d'évaporation (24) de la couche de revêtement (20),
afin de permettre à une rugosité moyenne arithmétique d'une surface du carbure de silicium d'être de 1 nanomètre ou moins, et de permettre à la précision planaire de la surface du carbure de silicium d'être de 30 microns ou moins, et de permettre à une épaisseur de la couche de revêtement (20) d'être de 5 microns ou plus à 10 microns ou moins; et
liaison de la surface de la couche de revêtement (20) à laquelle le meulage est appliqué et de la plaquette cristalline unique (50) l'une avec l'autre.

5. Procédé de fabrication d'un substrat lié (100) selon la revendication 4, où
la couche de revêtement (20) est évaporée sur le substrat polycristallin de carbure de silicium (10) à l'aide d'un procédé de dépôt physique en phase vapeur ou d'un procédé de dépôt chimique en phase vapeur.

6. Procédé de fabrication d'un substrat lié (100) selon la revendication 4 ou 5, où
le substrat polycristallin de carbure de silicium (10) constituant le substrat de support (30) est fabriqué par traitement de frittage.
